# EUROPEAN PATENT APPLICATION

(11) **EP 2 857 179 A1**
(43) Date of publication of application: **08.04.2015**
(21) Application number: 14187245.7
(22) Date of filing: 01.10.2014
(51) Int. Cl.: B29C 67/00, B33Y 30/00, B33Y 10/00

(54) **A moldless three-dimensional printing apparatus and method**

(30) Priority: 01.10.2013 US 201361885344 P
(71) Applicant: Summet Sys Inc., Mont-Royal H4T 1M1 (CA)
(72) Inventor: Cohen, Navi, Montreal, H3W 2H2 (CA); Venturi, John-Philip, Saint-Laurent, H4N 0A4 (CA)
(74) Representative: Wittmann, Günther

(57) **Abstract**

A moldless three-dimensional printing method and apparatus for applying the method. The method comprises intermittently feeding a continuous sheet material (102) into a build chamber (103), and maintaining a determined tension of the continuous sheet material (102). The method comprises ablating predetermined areas corresponding to internal part features of a layer of a manufactured object in a section of the sheet material. The method comprises positioning the section of the sheet material on top of a previous section of the sheet material. The method comprises bonding the section of sheet material to the previous section of the sheet material. The bonding includes applying a determined pressure and at least one determined temperature. The method comprises ablating external contours of the bonded section of the sheet material. The method further comprises controlling an ablation temperature, the determined pressure and the at least one determined temperature of the bonding.

## Description

### TECHNICAL FIELD

The present disclosure relates to the field of 3-dimensional printing and generation of three-dimensional object from digital files. More specifically, the present disclosure relates to a moldless three-dimensional printing apparatus and method.

### BACKGROUND

Additive manufacturing (AM), also known as 3D printing, is a process for creating three-dimensional objects directly from digital files. The process begins with a computer aided design (CAD) model or a 3D scan of an object. Software is then used to slice the CAD model or scan into a multitude of thin cross-sectional layers. This collection of layers is then sent to the AM system where the system builds the three-dimensional object layer by layer. Each layer is deposited or assembled on top of the previous layer until the object has been fully constructed. A support material is commonly used to support overhanging and complex features. In the current state of the art, a variety of AM processes exist that can build parts in plastic, metal and ceramic: material extrusion, material jetting, binder jetting, vat polymerization, powder bed fusion, and sheet lamination.

The AM technologies developed to date are primarily used for prototyping, model-making, and short run custom manufacturing. These technologies suffer from a number of disadvantages that have limited their ability to become viable manufacturing tools for higher volume production of end use parts.

State of the art AM technologies are severely limited in the range of materials that can be processed. The current processes capable of producing end-use parts are: material extrusion (thermoplastics), powder bed fusion (thermoplastics, metal), and UAM (metal). However, these processes use specially formatted filaments, powders and tapes resulting in raw material costs that are up to 100 times more expensive than traditional costs. Material jetting and vat polymerization processes use photopolymers that continue to cure when exposed to light even after they come out of the printer. This leads to aging and failure of photopolymer-based parts; therefore, these parts are limited to use in prototypes, models, and short-term use parts like jigs, fixtures, and surgical guides. Photopolymers cost hundreds of dollars (USD) per liter and are therefore extremely expensive relative to traditional plastics. With the exception of UAM, state of the art sheet lamination processes are limited to use with paper bonded with adhesive, and PVC plastic bonded with adhesive. Since adhesive is used, it is not possible to produce fully dense functional end-use parts, and so the current uses of sheet lamination processes are limited to prototyping and model-making.

A second disadvantage is the speed of current AM processes. With processes like material extrusion and powder bed fusion, it can take a couple of hours to produce a part the size of an average coffee mug. The processing speeds of these technologies are incredibly slow because they are 0-D processes: material is processed one point at a time. Additionally, the entire volume of material that makes up the printed objects is deposited, sintered or melted (depending on the process) which is time and energy consuming.

A third disadvantage of state of the art AM technologies is the quality of the parts produced. As compared to traditional manufacturing techniques like injection molding and CNC machining, many AM produced parts have reduced aesthetic and mechanical quality. Plastic parts produced by material extrusion processes exhibit significant stratification both aesthetically and mechanically. Because the material is extruded from a single nozzle as a thin strand with circular cross-section, two strands that are deposited beside or on top of each other do not make contact across the maximum width of the strand. As a result, the mechanical properties in the vertical Z axis are inferior to those in the X-Y axes, and the properties in the X-Y axes are inferior to those of injection molded parts. Metal and plastic parts produced by powder bed fusion processes typically exhibit mechanical properties that are comparable to traditionally manufactured parts, but these processes struggle to produce parts with consistent properties and dimensions. In powder bed fusion processes, the powdered material is kept at a temperature that is just below the material's melting point in order to reduce the layer forming time. Since elements that are located lower in the build volume are exposed to elevated temperatures for a longer period than those elements located higher up, the lower elements can distort or degrade (in the case of thermoplastics) during the build cycle. A part's quality, properties and dimensions are therefore a function of the part's location in the build volume. Additionally, powder bed fused parts are produced with a rough grainy surface finish and often require costly sanding, polishing and post processing in order to attain an acceptable aesthetic quality. Similar to powder bed fusion, metal and ceramic parts produced by binder jetting are also produced from a bed of powder and they also suffer from poor aesthetic quality.

Therefore, there is a need for a new moldless three-dimensional printing apparatus and method.

### SUMMARY

According to a first aspect, the present disclosure provides a moldless three-dimensional printing apparatus. The apparatus comprises a build chamber. The apparatus comprises a build table positioned in the build chamber to support a three-dimensional object being manufactured. The build table moves vertically. The apparatus comprises a mechanism for supplying a continuous sheet material. The apparatus comprises an ablation tool for ablating at least one predetermined area corresponding to internal part features of a layer of the manufactured object in a section of the sheet material in the build chamber. The apparatus comprises at least one additional roller operating in conjunction with the mechanism for supplying the continuous sheet material, for pulling the continuous sheet material inside the build chamber and maintaining a determined tension of the continuous sheet material; and for positioning the section of the sheet material on top of a previous section of the sheet material. The apparatus comprises a bonding tool installed within the build chamber, for bonding the section of sheet material positioned on top of the previous section of the sheet material. The bonding tool applies a determined pressure and at least one determined temperature. The ablation tool further ablates external contours of the bonded section of the sheet material positioned on top of the previous section of the sheet material.

According to a second aspect, the present disclosure provides a moldless three-dimensional printing method. The method comprises intermittently feeding a continuous sheet material into a build chamber. The method comprises maintaining a determined tension of the continuous sheet material. The method comprises ablating predetermined areas corresponding to internal part features of a layer of a manufactured object in a section of the sheet material. The method comprises positioning the section of the sheet material on top of a previous section of the sheet material. The method comprises bonding the section of sheet material to the previous section of the sheet material. The bonding includes applying a determined pressure and at least one determined temperature. The method comprises ablating external contours of the bonded section of the sheet material.

### BRIEF DESCRIPTION OF THE DRAWINGS

Embodiments of the disclosure will be described by way of example only with reference to the accompanying drawings, in which:
Figure 1 is a schematic side view of a moldless three-dimensional printing apparatus, in accordance with one embodiment;
Figures 2A to 2D illustrate example configurations of the moldless three-dimensional printing apparatus of Figure 1 at various steps during a layer forming process;
Figure 3 is a schematic side view of a moldless three-dimensional printing apparatus further comprising a cast film extruder, in accordance with one embodiment;
Figures 4A to 4E are perspective views of alternate embodiments of an ablation tool for the moldless three-dimensional printing apparatus of Figure 1;
Figures 5A to 5D are schematic side views of alternate embodiments of a bonding tool for the moldless three-dimensional printing apparatus of Figure 1;
Figure 6 is a process flow diagram for exemplary operation of the moldless three-dimensional printing apparatus of Figure 1, in accordance with one embodiment;
Figure 7 illustrates a moldless three-dimensional printing method, in accordance with one embodiment;
Figures 8A and 8B respectively illustrate details of an ablation and bonding operation, in accordance with one embodiment;
Figure 9 illustrates a bonding tool comprising heating and cooling units, in accordance with one embodiment; and
Figures 10A and 10B illustrate two variants of bonding tool comprising heating and cooling units, in accordance with two other embodiments.

### DETAILED DESCRIPTION

It will be appreciated that for simplicity and clarity of illustration, where considered appropriate, reference numerals may be repeated among the figures to indicate corresponding or analogous elements. In addition, numerous specific details are set forth in order to provide a thorough understanding of the examples described herein. However, it will be understood by those of ordinary skill in the art that the examples described herein may be practiced without these specific details. In other instances, well-known methods, procedures and components have not been described in detail so as not to obscure the examples described herein. Also, the description is not to be considered as limiting the scope of the examples described herein.

The term moldless three-dimensional (3D) printing apparatus (also referred to as an additive manufacturing apparatus) refers generally to a three-dimensional printing apparatus that allows the generation of a 3D object without for example requiring molding, thereby eliminating the cost associated with molding processes.

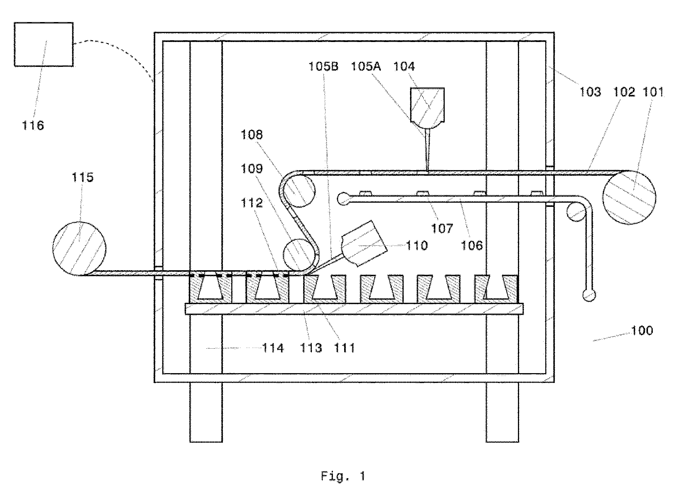

Referring to Figures 1, 7, 8A, 8B and 9, a moldless three-dimensional printing method 700 and apparatus 100 are represented. The apparatus 700 is an embodiment of a moldless 3D printing apparatus 100 capable of implementing the method 700. A high level description of the apparatus 100 is provided in relation to the method 700, and a more detailed description of the apparatus 100 will be given later in the description.

The method 700 comprises the step of intermittently feeding (step 705) a continuous sheet material 102 into a build chamber 103. The build chamber 103 is a component of the moldless 3D printing apparatus 100, inside which a three-dimensional object 111 is manufactured according to the method 700. The continuous sheet material 102 is used for printing successive layers of the manufactured object 111. The build chamber 103 maintains the manufactured object 111 and the continuous sheet material 102 in a controlled environment, for instance maintaining a controlled temperature and / or a controlled pressure of the build chamber 103.

The moldless 3D printing apparatus 100 comprises a build table 113 positioned in the build chamber 103 to support the three-dimensional object 111 being manufactured. The build table 113 moves vertically. For instance, the build table 113 moves downward each time a new layer of the object 111 is printed, as will be detailed later in the description.

The moldless 3D printing apparatus 100 comprises a continuous sheet supply mechanism 101 for supplying a continuous sheet material 102. The continuous sheet supply mechanism 101 is represented outside the build chamber 103 in Figure 1, but may alternatively be inside the build chamber 103. The continuous sheet supply mechanism 101 could for example comprise a material feed roller for carrying a roll of continuous sheet material (as shown in the Figures), or a cast film extruder for supplying the sheet material into the build chamber 103 (not shown).

The moldless 3D printing apparatus 100 comprises at least one additional roller operating in conjunction with the continuous sheet supply mechanism 101 for pulling the continuous sheet material 102 inside the build chamber 103, in order to implement step 705 of the method 700. Three additional rollers 108, 109 and 115 are presented in Figure 1, and will be detailed later in the description. However, more or less additional rollers may be used, depending on a particular embodiment of the moldless 3D printing apparatus 100. Furthermore, some of the additional rollers may be inside the build chamber 103 (e.g. 108 and 109) and some of the additional rollers may be outside the build chamber 103 (e.g. 115).

The method 700 comprises maintaining (step 710) a determined tension of the continuous sheet material 102. Maintaining the determined tension provides optimal conditions for performing the ablation and bonding operations described in the following paragraphs, in particular for performing these two operations with a required level of precisions, and for avoiding defaults in the manufactured object 111. The determined tension depends on various factors, including for example a type of material used for the continuous sheet material 102, a particular temperature or pressure of the continuous sheet material 102 when performing the ablation or bonding operations, etc.

The determined tension of the continuous sheet material 102 is maintained by the continuous sheet supply mechanism 101 and the at least one additional roller (e.g. 108, 109 and 115).

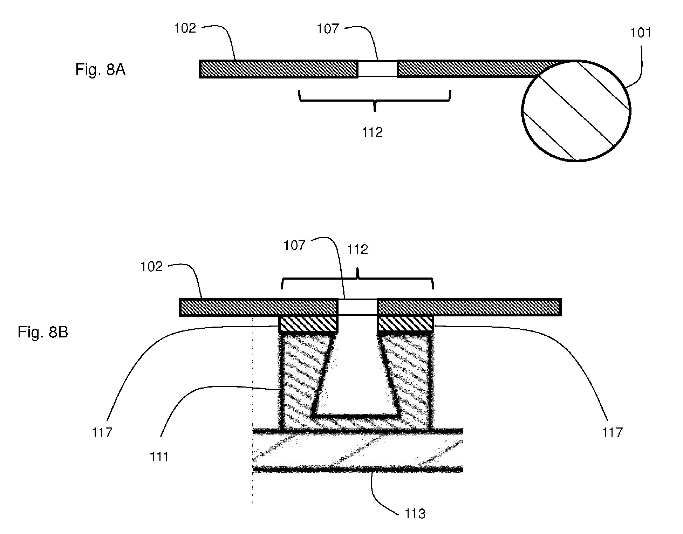

The method 700 further comprises ablating (step 715) predetermined areas 107 corresponding to internal part features of a layer of the manufactured object 111 in a section 112 of the sheet material 102. The predetermined areas 107 and section 112 of the sheet material 102 are illustrated in Figure 8A. The section 112 of the sheet material 102 corresponds to a specific layer of the manufactured object 111, and is used for printing this specific layer on the manufactured object 111, as will be described in the following paragraphs. Step 715 prepares the section 112 before it is printed on the object 111, by eliminating the areas 107 (e.g. voids) which are not present in the layer of the object 111 corresponding to section 112.

An ablation tool 104 performs the ablation of the predetermined areas 107 (step 715). In a particular embodiment, the ablation tool 104 is a pulsed laser. The ablation consists in ablating particles of the sheet material 102 with the pulsed laser, to realize a high precision cut to eliminate the unwanted predetermined areas 107. For example, the pulsed laser may have a precision of two microns. The ablation tool 104 may be installed directly within the build chamber 103, or outside the build chamber but in optical line of sight of the section 112 of the sheet material 102, for example through a window.

The method 700 then positions (step 720) the section 112 of the sheet material 102 on top of a previous section 117 of the sheet material 102. The section 112 of the sheet material 102 and the previous section 117 of the sheet material 102 are illustrated in Figure 8B.

The continuous sheet supply mechanism 101 and the at least one additional roller (e.g. 108, 109 and 115) operate in conjunction for performing the step 720 of positioning the section 112 on top of the previous section 117. The section 117 corresponds to the last layer of the object 111 which has been printed, and the section 112 corresponds to the next layer of the object 111 which is currently printed on top of the last printed layer.

The method 700 then bonds (step 725) the section 112 of sheet material 102 to the previous section 117 of the sheet material 102. The bonding step 725 comprises applying a determined pressure and at least one determined temperature.

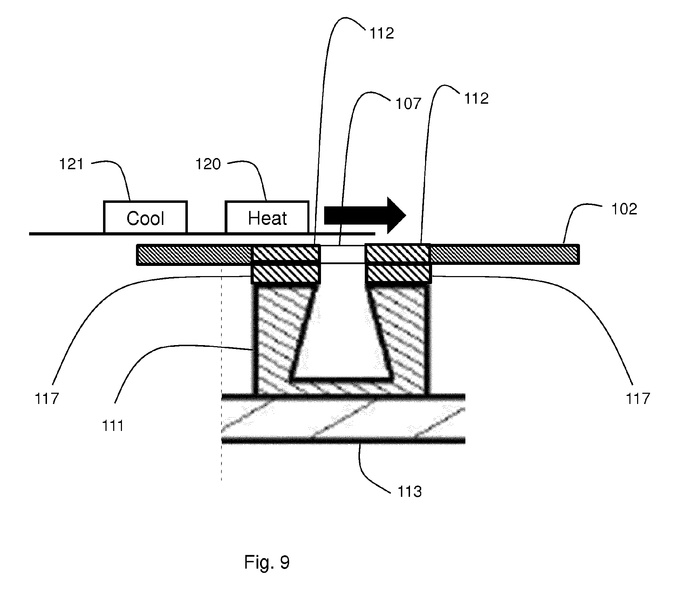

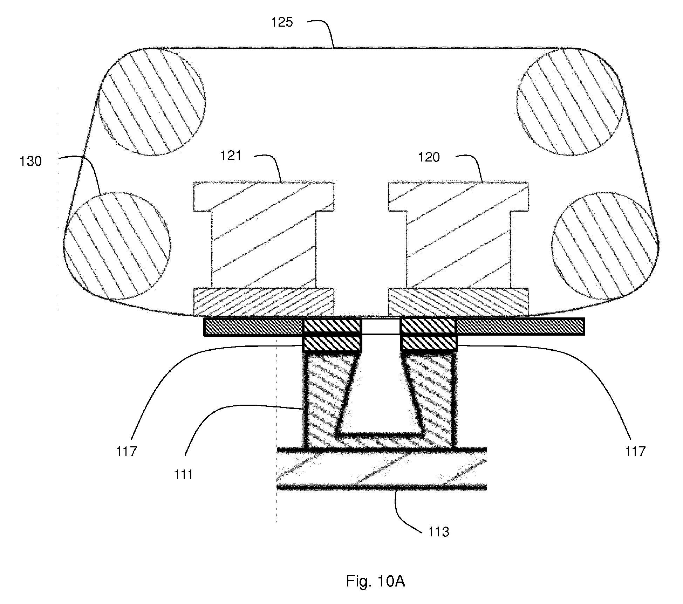

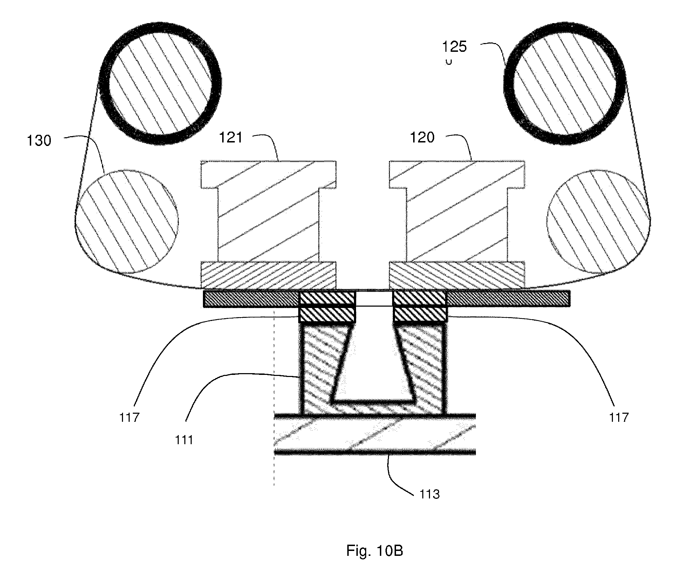

A bonding tool 110 installed within the build chamber 103 performs the step 715 of bonding the section 112 to the previous section 117. In a particular embodiment illustrated in Figure 9, the bonding tool 110 comprises a heating unit 120 and a cooling unit 121 successively positioned above the section 112 of the sheet material 102 positioned on top of the previous section 117 of the sheet material 102, so as to transfer heat and cool successively thereto. In a particular embodiment illustrated in Figures 10A and 10B, the heating unit 120 and the cooling unit 121 transfer successively heat and cold through a thermal transfer sheet 125 and rolls 130 mounted together in a carriage assembly that is displaced linearly by any appropriate electro-mechanical actuation system (linear motors, servo or stepper motor driven lead screws, belt drives, etc.), and controlled by the computer device.

The method 700 continues with ablating (step 730) external contours of the bonded section 112 of the sheet material 102 positioned on top of the previous section 117 of the sheet material 102. This step consists in a finishing operation that is complimentary to the ablation 715 of the predetermined areas 107. Steps 715 and 730 respectively create the internal and external contours of the layer of the object 111 printed with the section 112 of sheet material 102.

The ablation (step 730) is also performed by the ablation tool 104. In an alternative embodiment, another ablation tool (not represented in the Figures) may be used for performing step 730.

In a particular aspect, a single roll with the same sheet material 102 having different thicknesses may be used. Alternatively, different rolls with different sheet materials 102 having different properties may be used. For example, different material thicknesses may be used to vary build speed and resolution, so as to optimize the moldless three-dimensional printing process. Using different rolls with different materials allows the moldless three-dimensional printing of composite parts and/or variation of mechanical properties (strength, elasticity, hardness, etc.) within a single manufactured object 111.

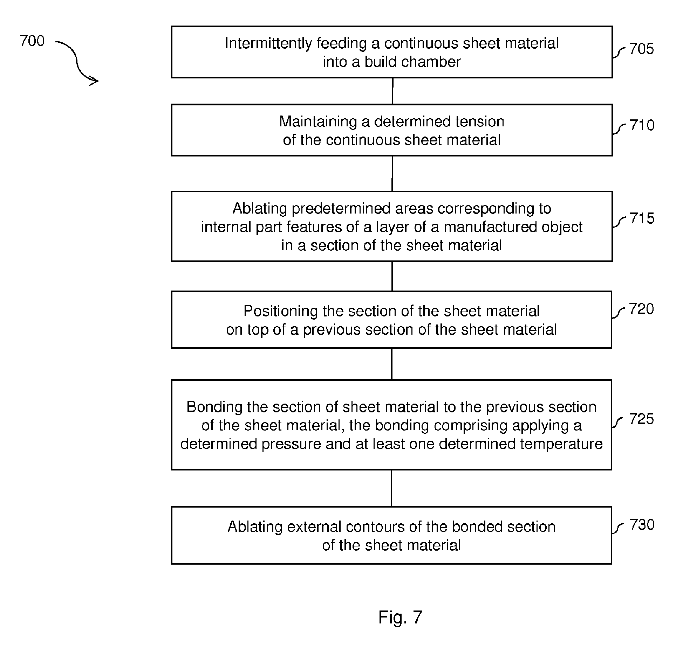

Although not represented in Figure 7 for simplification purposes, the method 700 further comprises controlling operating parameters for performing several steps of the method 700. For this purpose, the moldless 3D printing apparatus 100 further comprises a computing device 116 for controlling operating parameters of the ablation tool 104, the bonding tool 110, the continuous sheet supply mechanism 101, the at least one additional roller (e.g. 108, 109 and 115), and the build table 113.

In a particular aspect, an ablation temperature of the ablation tool 104 is controlled by the computing device 116 for performing at least one of the ablation steps 715 and 730 of the method 700.

In another particular aspect, the determined pressure and the at least one determined temperature of the bonding tool 110 are controlled by the computing device 116 for performing the bonding (step 725) of the method 700.

In still another particular aspect, the ablation tool 104 is a pulsed laser and the computing device 116 controls the following operating parameters of the pulsed laser: a frequency of the laser, a duration of pulses of the laser, a power of the laser, and a speed of displacement of the laser. The operating parameters of the pulsed laser may be determined based on at least one of the following: type of the sheet material 102, thickness of the sheet material 102, type of pulsed laser, and surface temperature of the section 112 of the sheet material 102.

In yet another particular aspect, the bonding tool 110 comprises the heating unit 120 and the cooling unit 121 as represented in Figures 9, 10A and 10B. The computing device 116 controls the following operating parameters of the units: interface pressure of the heating unit 120, interface pressure of the cooling unit 121, temperature of the heating unit 120, temperature of the cooling unit 121, speed of displacement of the heating unit 120, and speed of displacement of the cooling unit 121. The operating parameters of the heating 120 and cooling 121 units may be determined based on at least one of the following: type of the sheet material 102, and thickness of the sheet material 102. Additionally, the heating 120 and cooling 121 units are designed to have a respective particular length, as well as a particular distance between them. The lengths and distance may also depend on the type of the sheet material 102 and thickness of the sheet material 102.

In another particular aspect, the computing device 116 calculates ablation paths of the ablation tool 104 (the ablation paths correspond to the displacement of the ablation tool 104 for performing the ablation steps 715 or 730 of the method 700). The ablation paths may be calculated based on a computer aided design (CAD) model or a 3D scan of the manufactured object 111.

In still another particular aspect, the computing device 116 controls a tension applied by the continuous sheet supply mechanism 101 in conjunction with the at least one additional roller (e.g. 108, 109 and 115) on the sheet material 102.

In yet another particular aspect, the computing device 116 determines the position of the section 112 of the sheet material 102 in the roll of continuous sheet material 102. The position may be determined based on a computer aided design (CAD) model or a 3D scan of the manufactured object 111. The computing device 116 further actuates the continuous sheet supply mechanism 101 in conjunction with the at least one additional roller (e.g. 108, 109 and 115) for positioning the section 112 of the sheet material 102 on top of the previous section 117 of the sheet material 102.

In another particular aspect, the computing device 116 determines that the external contours of the bonded section 112 have been ablated and triggers a downward vertical movement of the build table 113 by a distance corresponding to a thickness of the sheet material 102.

In still another particular aspect, the computing device 116 controls at least one of the following: temperature of the build chamber 103, temperature of the build table 113, and ventilation of the build chamber 103.

In the following, additional details are provided with respect to the components and functionalities of the moldless 3D printing apparatus 100.

Referring to Figures 1 and 8A, a schematic side view of one embodiment of a moldless 3D printing apparatus 100 is represented. In one example, the size of the moldless 3D printing apparatus is approximately 3m x 1.5m x 2m (xyz). However, other dimensions may be envisaged.

The continuous sheet supply mechanism 101 supplies a continuous sheet material 102. The continuous sheet supply mechanism 101 is positioned adjacent to a build chamber 103 and the sheet material 102 is intermittently fed into the build chamber 103 such that the sheet material 102 is initially in a suspended position. An ablation tool 104 is disposed within the build chamber 103 (as shown), or outside the build chamber 103 but in optic line of sight with the predetermined area(s) 107 (not shown) in order to ablate predetermined area(s) 107, corresponding to internal part features of a layer of an object being manufactured, in a section 112 of the sheet material 102. For instance, the determined areas 107 of the sheet material 102 correspond to voids in the objects being manufactured or areas 107 whose removal facilitates the manufacturing process. The ablation tool 104 may comprise a pulsed fiber laser coupled with a galvanometer and the ablation tool 104 is mounted on a 3-axis gantry (not shown in Figure 1) so that it can be translated within the build chamber 103. A movable scrap collector 106 is disposed below the suspended sheet material 102 and beneath the ablation tool 104 in order to catch or receive the areas 107 as they are detached by the ablation process. The scrap collector 106 is mounted on linear rails and is preferably driven by one or more of: a lead screw, linear motor, or belt system. The scrap collector 106 can be displaced linearly along the rails so that it does not obstruct the bonding process and in order to evacuate the ablated areas 107. A bonding assembly is also disposed within the build chamber 103 comprising: at least one tensioning roller 108, at least one press roller 109, and at least one bonding tool 110. The bonding assembly components are collectively mounted on a linear stage that is preferably driven by either linear motors or by lead screws coupled with servo or stepper motors. The bonding tool 110 may comprise for example a pulsed fiber laser coupled with a galvanometer. A build table 113 is positioned in the build chamber 103 to support each three-dimensional object 111 as it is built. The build table 113 is movable in a vertical direction and is driven by four lead screws 114 which are driven by independent servo or stepper motors. After each layer is formed, the build table 113 is lowered by a distance corresponding to the thickness of the sheet material 102 that is being processed.

The motors are preferably controlled such that their operation is coordinated. Disposed adjacent to the build chamber 103 directly opposite the continuous sheet supply mechanism 101 (e.g. opposing ends of the build chamber 103) is a scrap material collector roller 115.

Referring to Figures 1, 2A-2D, 8A and 8B, the operation of the moldless 3D printing apparatus 100 is represented. As depicted, it begins with loading a roll of sheet material 102 onto the continuous sheet supply mechanism 101. The sheet material 102 may be a filled or unfilled thermoplastic, metal, composite, powder in carrier resin (for metal and ceramic "green" parts), or any other material that can be produced in sheet form and can be fused together. In order to begin producing parts, the end of the roll of sheet material 102 is drawn into the build chamber 103, through the bonding assembly, and fixed or otherwise attached to the collector roller 115.

A computing device and controller, hereafter collectively referred to as the "controller computing device" 116, provides instructions to the moldless 3D printing apparatus 100 to control the layer forming process. The controller computing device 116 comprises a memory and/or database configured for having the instructions stored thereon, and a processor for executing said instructions and communicating with the moldless 3D printing apparatus 100 (e.g. with the ablation tool and the bonding tool) for controlling the design and manufacturing of the 3-D object generated from the moldless 3D printing apparatus 100. Thus, the computer readable instructions are stored in a memory or another non-transitory computer readable storage medium, for execution by a general purpose or a specialized processor, causing the processor to control operating parameters of components of the moldless 3D printing apparatus (e.g. the ablation tool and the bonding tool), to generate a 3D object as will be described in further detail below. The connection between the controller computing device 116 and the moldless 3D printing apparatus 100 can be wired and/or wireless (such as Bluetooth™ for example).

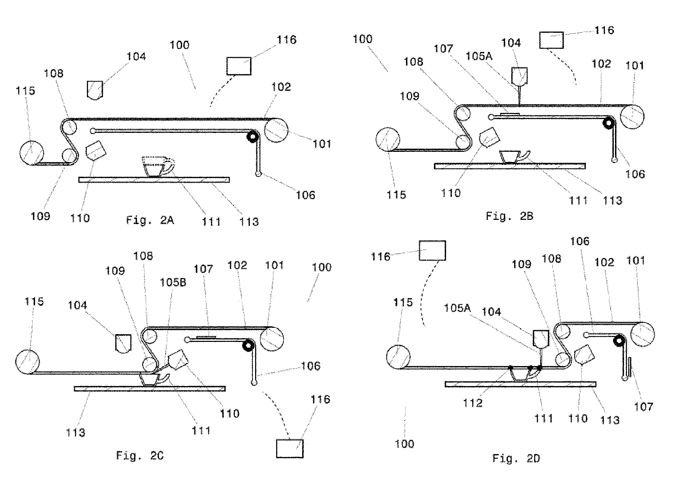

The process of forming a layer of the object being manufactured involves advancing a virgin or unutilized portion of sheet material 102 into the build chamber 103. The continuous sheet supply mechanism 101 and collector roller 115 are rotated in tandem to advance the portion of sheet material 102. The apparatus 100 then performs a pre-cut step, a bonding step, and a final cut step. The continuous sheet supply mechanism 101 and collector roller 115 are static during these three steps. To start forming a layer, the bonding assembly and the ablation tool 104 are homed to their starting position at the end of the build chamber 103 near the collector roller 115 (shown in Figure 2A). The ablation tool 104 then performs a pre-cut step (shown in Figures 2B and 8A) in which it travels laterally above the suspended sheet material 102 and ablates predetermined areas 107, which correspond to internal part features of a layer of the manufactured object, in a section 112 of the sheet material. For instance, the areas 107 correspond to one or more internal voids in the three-dimensional objects 111 being built.

The controller computing device 116 controls the X-Y displacement of the galvanometer with the scan path of the galvanometer mirror in order to minimize the duration of the pre-cut step. The areas 107 that are ablated fall as scrap material onto the scrap collector 106 disposed below the suspended sheet material 102 (underneath the areas 107 of the sheet material 102 being ablated by the ablation tool 104). As the ablation tool 104 performs the pre-cut, the scrap collector 106 is progressively moved from its horizontal position inside the build chamber 103 to a vertical position outside the build chamber 103. Once outside the build chamber 103, the scrap material falls from the scrap collector 106 into a collection bin (not shown in the drawings).

To initiate the bonding step (shown in Figure 2C and 8B), the controller computing device 116 sends a signal to the bonding assembly. A predetermined time delay separates the start of the pre-cut step and that of the bonding step. The duration of the time delay is calculated by the controller computing device 116 for each section of the of the sheet material corresponding to a layer of the object begin manufactured. The duration is calculated to minimize the waiting time between the three layer forming steps. During the bonding step, the bonding assembly is translated in a single axis from the side of the build chamber 103 adjacent to the collector roller 115 to the side adjacent to the continuous sheet supply mechanism 101. As the bonding assembly advances, the sheet material 102 is drawn from its first suspended position into a second position such that the sheet material 102 is in contact with the particular object 111 being built. The bonding assembly is advanced step by step, and it is driven either by servo-controlled linear motors or lead screw(s) driven by (a) servo or stepper motor(s). Prior to each stepped advance of the bonding assembly, the galvanometer of the bonding tool 110 selectively scans the pulsed laser beam 105B (e.g. Figure 2C) precisely along a line where a new section 112 of sheet material 102 (corresponding to a new layer of the objects being built 111) contacts a previous section 117 of sheet material 102 (corresponding to a previous layer of the objects being built 111) previously bonded to the objects being built 111. The pulsed laser beam 105B is scanned across the portions of the line that will form part of the newly bonded section 112. The pulsed laser beam 105B simultaneously heats the new section 112 of sheet material 102 (corresponding to the new layer of the objects 111) and the previous section 117 of sheet material 102 (corresponding to the previous layer of the objects 111) located at the uppermost surface of the objects 111. The pulsed laser beam 105B heats these new 112 and previous 117 sections to a pre-defined temperature that is sufficient to achieve fully-welded homogenous thermoplastic, metal, and composite parts. Immediately after the new 112 and previous 117 sections are heated, the bonding assembly is advanced and the heated new 112 and previous 117 sections (corresponding to the new layer and the previous layer at the uppermost surface of the objects 111) are pressed into contact by the press roller 109 which applies pressure and additional heat. The heat applied by the press roller 109 serves to pre-heat the new section 112 of sheet material 102 prior to bonding and also to insulate the joint between the newly bonded section 112 and the previously bonded section 117 at the surface of the objects 111, thus ensuring a solid weld (e.g. shown in Figure 2D). As the bonding assembly travels, the position and rotational velocity of the tensioning roller 108 are dynamically adjusted to ensure that the sheet material 102 does not distort, stretch, slip or flutter.

For the final step (Figure 2D), the ablation tool 104 returns to its starting position and then descends vertically so that the pulsed laser beam 105A is focused on the sheet material 102 in its new position. The ablation tool 104 then travels laterally across the build chamber 103 and ablates external contours of the newly bonded section 112. In so doing, the remaining excess sheet material 102 is released from the objects 111 being built. Once again, the controller computing device 116 is configured to coordinate the X-Y movement of the vaporizing tool 104 with the scan path of the galvanometer, in order to minimize the ablation time.

After the three layer forming steps are complete, the continuous sheet supply mechanism 101 and the collector roller 115 are configured to rotate in order to advance a new portion of sheet material 102 into the build chamber 103. While the sheet 102 is advanced, the ablation tool 104 and the bonding assembly are returned to their starting position in preparation for the next layer. The above process is repeated layer upon layer of the object 111, until the desired product is fully formed via the object 111. The controller computing device 116 uses predetermined data and feedback from the moldless 3D printing apparatus 100 to determine when the process is complete.

There are numerous alternate embodiments associated with various aspects of the moldless 3D printing apparatus 100 described in relation to Figures 1 and 2A-2D.

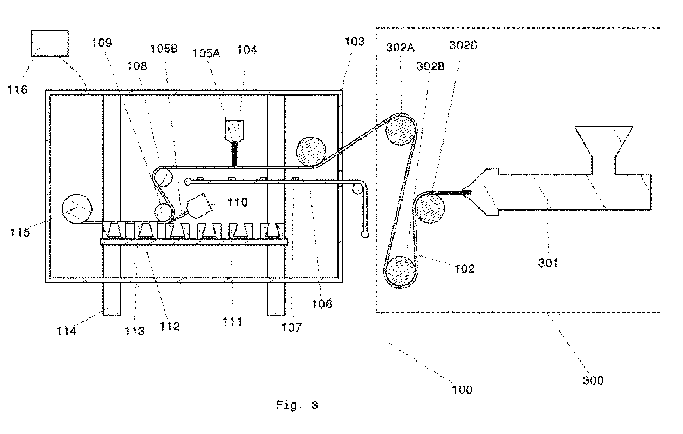

Referring to Figure 3, an alternative embodiment of a moldless 3D printing apparatus 100 is represented. The moldless 3D printing apparatus 100 is associated with a material feed system 300 that comprises a cast film extruder 301 and a multitude of tensioning rollers 302A, 302B, 302C to continuously extrude film (sheet material 102) for use in the moldless 3D printing process described herein. Cast film extrusion is a continuous process, so the tensioning rollers 302A-C are used to compensate for the intermittent nature of the moldless 3D printing process. While a layer is being formed, the distance between the tensioning rollers 302A-C is increased in order to support the new length of extruded film 102 while immobilizing the section of film 102 inside the build chamber. After a layer is formed, the distance between the tensioning rollers 302A-C is decreased to allow the new length of extruded film 102 to advance into the build chamber 103. This embodiment may be used with filled or unfilled thermoplastic materials, carrier resins with metal or ceramic powder, or any other material that can be extruded as cast film.

A third embodiment (not shown in the Figures) of the material feed system 300 involves the use of individual rectangular sheets of material. The sheets are stacked together, and are fed one by one into the build chamber.

In addition to the pulsed fiber laser described previously, the ablation tool 104 (described in relation to Figures 1, 2A-2D, 3, 4A-4E, and 5A-5D) may alternatively use a galvanometer coupled with a CO2 laser, diode pumped solid state (DPSS) laser, laser diode, fiber-delivered laser diode, excimer laser, or any other suitable pulsed laser as envisaged by a person skilled in the art. The lasers listed above will collectively be referred to as "the pulsed laser" hereafter.

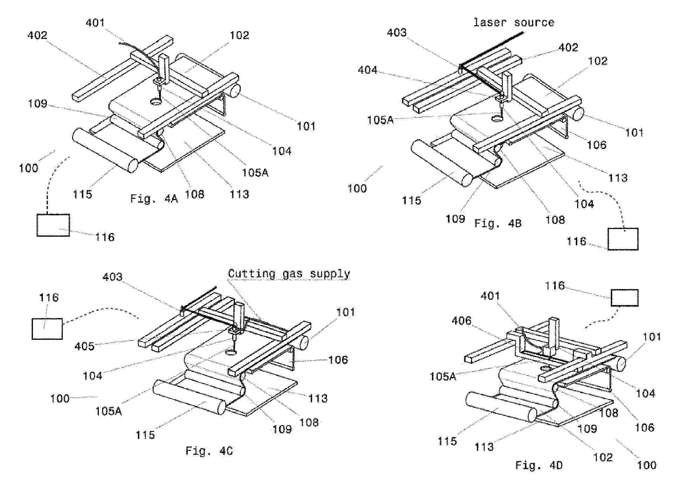

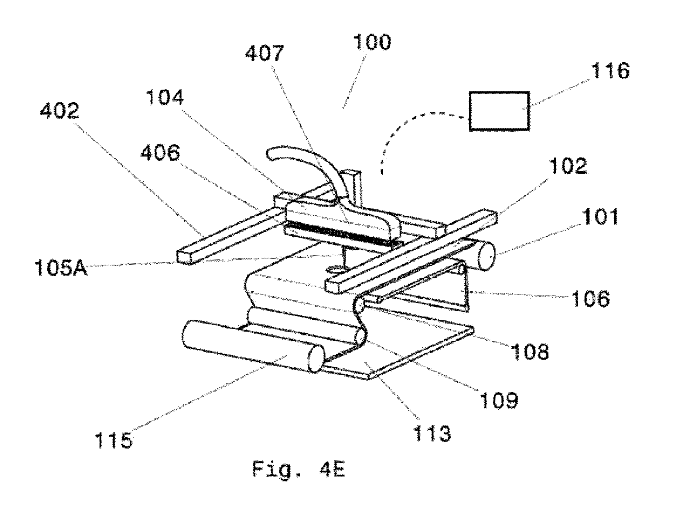

Referring to Figures 4A-4E, alternate embodiments of the ablation tool 104 which is configured to communicate with the controller computing device 116 are represented. Figure 4A shows a pulsed fiber laser 401 mounted directly on an X-Y-Z gantry 402. Figure 4B shows an optical array 403 configured to direct a pulsed laser beam 105A to a cutting head 404. Figure 4C shows a gas-assisted pulsed laser cutting nozzle 405. Figure 4D shows a pulsed laser 401 reflected by a scanning mirror through a liquid crystal or MEMS-based filter 406 onto the sheet material. Figure 4E shows a pulsed laser transmitted through a fiber optic bundle that is shaped into an n Xn array 407 and is selectively transmitted through a liquid crystal or MEMS-based filter 406.

Further embodiments of the ablation tool 104 (not shown in the Figures) include but are not limited to: a pulsed laser selectively projected by a liquid crystal or MEMS-based mirror device; an n X n pulsed laser diode array transmitted through a liquid crystal or MEMS-based filter; a drag knife mounted on an X-Y-Z gantry system; and an electron beam cutting tool.

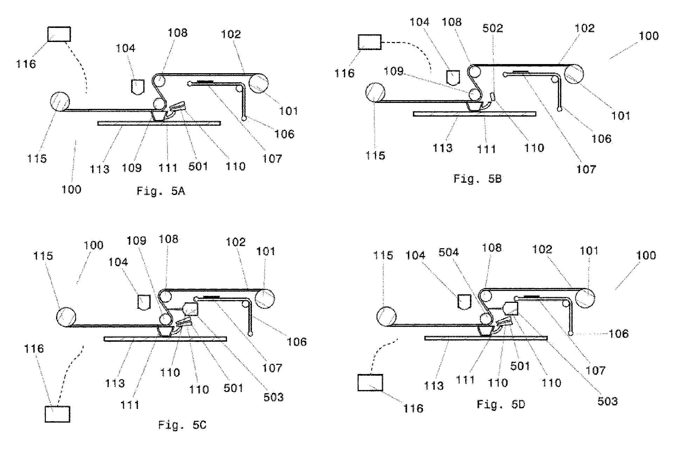

Referring to Figures 5A-5D, 9, 10A and 10B, multiple embodiments of the bonding tool 110, which is also configured to communicate with the controller computing device 116, are represented. The embodiment illustrated in Fig 5A comprises a hot gas knife 501 directed at the joint between the new layer (new section 112 of the sheet material 102) and the previously formed layer (previous section 117 of the sheet material 102). Figure 5B shows a diffuse infrared heater 502 disposed between the new layer 112 and the previously formed layer 117. Figure 5C shows a pulsed laser coupled with a galvanometer 503 and paired with a hot gas knife 501 or diffuse infrared heater 502. Figure 5D shows a pulsed laser coupled with a galvanometer 503 and paired with an ultrasonic welding roller 504. Figures 9, 10A and 10B illustrate variants of a consecutive hot and cold thermal exchange process. The consecutive hot and cold thermal exchange is effectuated by consecutively placing a heating unit 120 and cooling unit 121 in proximity and thermal exchange with the sheet material 102. The heating unit 120 and cooling unit 121 are moved along the sheet material, at a speed determined by the controller computing device 116. The speed is determined based on the type and thickness of the sheet of material 102, and conditions in the build chamber. In Figure 10A and 10B, the heating unit 120 and cooling unit 121 are mounted above and in contact through the thermal transfer sheet 125 and rolls 130 mounted together in a carriage assembly that is displaced linearly by any appropriate electro-mechanical actuation system (linear motors, servo or stepper motor driven lead screws, belt drives, etc.), and controlled by the controller computing device 116.

Reverting to the embodiment shown in Figure 5C, the pulsed laser 503 ablates a pattern to a predetermined depth on the underside of the sheet 102, but does not cut all the way through the sheet 102. In Figure 5C, this step is depicted as occurring between the pre-cut step and the bonding step. However, the pattern ablation may alternatively occur prior to the pre-cut step. When a new section 112 of sheet 102 (corresponding to a new layer of the manufactured object 111) is pressed by the press roller 109 against the previously formed section 117 (corresponding to the previously formed layer of the manufactured object 111), the ablated pattern creates gaps where bonding is not desired; thus ensuring that the desired areas are bonded together and the remainder of the sheet 102 remains unbonded. The hot gas knife 501, or diffuse infrared heater 502, heats the joint of the new 112 and previous 117 section sufficiently to create a full weld. The embodiment shown in Figure 5D also involves a pattern ablation step using a pulsed laser and galvanometer 503. However, bonding is performed by an ultrasonic welding roller 504. In this embodiment, the ultrasonic welding roller 504 takes the place of the press roller 109. A hot gas knife 501 or diffuse infrared heater 502 (not shown in Figure 5D) may also be disposed to heat the underside of the new section 112 prior to bonding with the ultrasonic welding roller 504.

Further embodiments of the bonding tool (not shown in the drawings) include but are not limited to the following: a pulsed laser and line beam generating optics configured to direct a pulsed laser line along the complete length of the joint between the new section 112 and the previous section 117; a pulsed laser and line beam generating optics coupled with a galvanometer to scan a pulsed laser line along the joint; a pulsed laser and line beam generating optics directed at the joint through a selectively transmissive liquid crystal-based filter; a pulsed laser coupled with a scanning mirror directed at the joint through a selectively transmissive liquid crystal-based filter; a pulsed laser directly reflected towards the joint by a MEMS-based micromirror array; a pulsed laser reflected at the joint by a liquid crystal based reflective filter; an electron beam directed at the joint; and a stream of plasma directed at the joint.

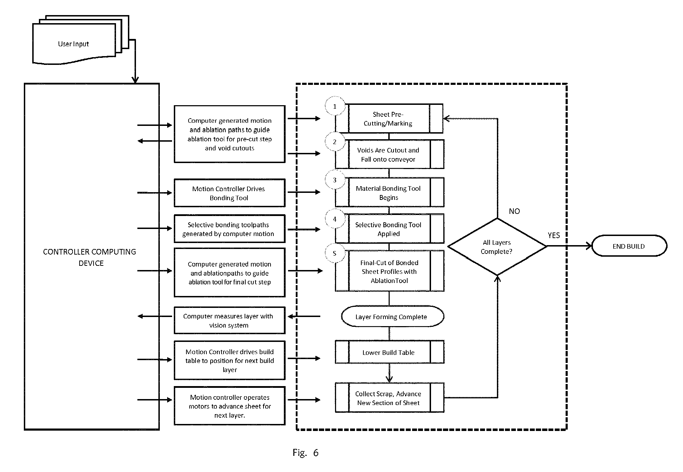

Referring to Figure 6, a process flow diagram for exemplary operation of the moldless 3D printing apparatus 100 depicted in Figures 1 and 2A-2D is represented in accordance with one embodiment. In the embodiment shown, the process begins with input data to the controller computing device 116. In one aspect, the input preferably takes the form of a CAD file. However, other types of input files for providing instructions to the moldess 3D printing apparatus 100 can be envisaged. The input files can be stored on a database and/or storage of the controller computing device 116. Based on the instructions provided on the input (e.g. CAD file), the controller computing device 116 then determines the ablation paths for the ablation tool 104 in order to perform the pre-cut step. After the start of the pre-cut step, the controller computing device 116 calculates a pre-defined time delay after which it 116 initiates the bonding step. During the bonding step, the controller computing device 116 controls the galvanometer of the bonding tool 110 such that it scans the pulsed laser beam 105B along predetermined selective bonding tool paths (e.g. based on predetermined bonding criteria provided in the input file). The controller computing device 116 also coordinates and controls the operation of: the linear motion components which drive the bonding assembly, the heating elements in the tensioning roller 108 and press roller 109, the rotation of the press roller 109, and the rotation and position of the tensioning roller 108. After the initiation of the bonding step, the controller computing device 116 calculates a required time delay after which it 116 initiates the final cut step. The controller computing device 116 determines ablation paths for the ablation tool 104 to execute during the final cut step. The galvanometer of the ablation tool 104 is driven such that it scans the pulsed laser beam 105A along the final cut ablation paths. Following the final cut, the three-dimensional objects 111 are monitored by the controller computing device 116 with the aid of a vision system. The vision system collects data which the controller computing device 116 compares against the user input data. The controller computing device 116 then determines if the build is complete or if the process is to be repeated in order to form a subsequent layer. In the case where a subsequent layer needs to be formed, the build table 113 is lowered by a distance equivalent to the layer height and a new portion of sheet material 102 is advanced into the build chamber 103.

In the above description, numerous exemplary advantages of one or more embodiments of the moldless 3D printing apparatus 100 are apparent as follows:
- The moldless 3D printing process can process a wide range of materials including plastics, metals, ceramics, composites, and powders in carrier resins.
- The apparatus can accommodate various sheet dimensions allowing users to select the material format of their choice.
- Plastic film, composite sheet, and metal foil are commonly available products. Therefore the cost of raw materials used is significantly lower than the cost of specialty materials used in other AM processes.

- The process yields fully dense end-use parts because no adhesive is used to bond the layers of sheet material.
- Since the bonding assembly spans the width of the build volume, multiple parts are built simultaneously in a 1-D or 2-D process. As a result, the moldless 3D printing apparatus can achieve build speeds that are 2-5 times faster than other AM technologies.
- The moldless 3D printing apparatus 100 (illustrated in Figures 1, 2A-2D, 3, 4A-4E, 5A-5D, and 6) is advantageous as it allows building multiple parts simultaneously in a 1-D or 2-D process resulting in repeatable high quality parts, since processing a line (1-D) or surface (2-D) simultaneously speeds up the 3-D printing process.
- Precision ablation and bonding technologies are used for layer forming which yields a high quality surface finish on the manufactured parts.
- By focusing the energy sufficient for bonding at the joint between a new layer and previously formed layers, the energy consumed by the machine is kept to a minimum.

It will be appreciated that the examples and corresponding diagrams used herein are for illustrative purposes only. Different configurations and terminology can be used without departing from the principles expressed herein. For instance, components and modules can be added, deleted, modified, or arranged with differing connections without departing from these principles.

It will be appreciated that any module or component exemplified herein that executes instructions may include or otherwise have access to computer readable media such as storage media, computer storage media, or data storage devices (removable and/or non-removable) such as, for example, magnetic disks, optical disks, or tape. Computer storage media may include volatile and non-volatile, removable and non-removable media implemented in any method or technology for storage of information, such as computer readable instructions, data structures, program modules, or other data. Examples of computer storage media include RAM, ROM, EEPROM, flash memory or other memory technology, CD-ROM, digital versatile disks (DVD) or other optical storage, magnetic cassettes, magnetic tape, magnetic disk storage or other magnetic storage devices, or any other medium which can be used to store the desired information and which can be accessed by an application, module, or both. Any such computer storage media may be part of the controller computing device associated with the moldless 3D printing apparatus 100, any component of or related to the controller computing device for the moldless 3D printing apparatus 100, etc.; or accessible or connectable thereto. Any application or module herein described may be implemented using computer readable/executable instructions that may be stored or otherwise held by such computer readable media.

The steps or operations in the flow charts and diagrams described herein are just for example. There may be many variations to these steps or operations without departing from the principles discussed above. For instance, the steps may be performed in a differing order, or steps may be added, deleted, or modified.

Although the present disclosure has been described hereinabove by way of non-restrictive, illustrative embodiments thereof, these embodiments may be modified at will within the scope of the appended claims without departing from the spirit and nature of the present disclosure.

## Claims

1. A moldless three-dimensional printing apparatus comprising:
a build chamber;
a build table positioned in the build chamber to support a three-dimensional object being manufactured, the build table moving vertically;
a continuous sheet supply mechanism for supplying a continuous sheet material;
an ablation tool for ablating at least one predetermined area corresponding to internal part features of a layer of the manufactured object in a section of the sheet material in the build chamber;
at least one additional roller operating in conjunction with the continuous sheet supply mechanism for:
pulling the continuous sheet material inside the build chamber and maintaining a determined tension of the continuous sheet material; and
positioning the section of the sheet material on top of a previous section of the sheet material; and
a bonding tool installed within the build chamber for bonding the section of sheet material positioned on top of the previous section of the sheet material, the bonding tool applying a determined pressure and at least one determined temperature; and
the ablation tool further ablating external contours of the bonded section of the sheet material positioned on top of the previous section of the sheet material.

2. The moldless three-dimensional printing apparatus of claim 1, further comprising a computing device for controlling operating parameters of the ablation tool, the bonding tool, the continuous sheet supply mechanism (101), the at least one additional roller, and the build table.

3. The moldless three-dimensional printing apparatus of claim 2, wherein the ablation tool is a pulsed laser.

4. The moldless three-dimensional printing apparatus of claim 3, wherein controlling operating parameters of the pulsed laser comprises determining at least one of the following: a frequency of the laser, a duration of pulses of the laser, a power of the laser, and a speed of displacement of the laser, and wherein the operating parameters of the pulsed laser are determined based on at least one of the following: a type of sheet material being used, a thickness of the sheet material, a type of pulsed laser used, and a surface temperature of the section of the sheet material.

5. The moldless three-dimensional printing apparatus of claim 2, wherein the bonding tool comprises a heating unit and a cooling unit successively positioned above the section of the sheet material positioned on top of the previous section of the sheet material so as to transfer heat and cool successively thereto, and wherein controlling operating parameters of the bonding tool comprises determining at least one of the following: an interface pressure of the heating unit, an interface pressure of the cooling unit, a temperature of the heating unit, a temperature of the cooling unit, a speed of displacement of the heating unit, and a speed of displacement of the cooling unit.

6. The moldless three-dimensional printing apparatus of claim 2, wherein controlling operating parameters of the ablation tool comprises calculating ablation paths of the ablation tool, the ablation paths being calculated based on a computer aided design (CAD) model or a 3D scan.

7. The moldless three-dimensional printing apparatus of claim 2, wherein controlling operating parameters of the bonding tool comprises actuating the bonding tool for performing the bonding based on a predetermined time delay separating the start of the ablation and the start of the bonding, the predetermined time delay being calculated for each section of the sheet material.

8. The moldless three-dimensional printing apparatus of claim 2, wherein controlling operating parameters of the build table comprises determining that the external contours of the bonded section have been ablated and triggering a downward vertical movement of the build table by a distance corresponding to a thickness of the sheet material.

9. The moldless three-dimensional printing apparatus of claim 2, wherein the computing device further controls at least one of the following: temperature of the build chamber, temperature of the build table, and ventilation of the build chamber.

10. The moldless three-dimensional printing apparatus of claim 1, wherein the continuous sheet material consists of one of the following: filled thermoplastic, unfilled thermoplastic, metal, composite, and powder in carrier resin.

11. A moldless three-dimensional printing method comprising:
intermittently feeding a continuous sheet material into a build chamber;
maintaining a determined tension of the continuous sheet material;
ablating predetermined areas corresponding to internal part features of a layer of a manufactured object in a section of the sheet material;
positioning the section of the sheet material on top of a previous section of the sheet material;
bonding the section of sheet material to the previous section of the sheet material, the bonding comprising applying a determined pressure and at least one determined temperature; and
ablating external contours of the bonded section of the sheet material.

12. The moldless three-dimensional printing method of claim 11, further comprising controlling an ablation temperature, and the determined pressure and at least one determined temperature of the bonding.

13. The moldless three-dimensional printing method of claim 12, wherein the ablation is performed by a pulsed laser.

14. The moldless three-dimensional printing method of claim 13, further comprising controlling at least one of the following operating parameters of the pulsed laser: frequency, duration of pulses, power, and speed of displacement, and wherein the operating parameters of the pulsed laser are determined based on at least one of the following: type of sheet material, thickness of the sheet material, type of pulsed laser, and surface temperature of the section of the sheet material.

15. The moldless three-dimensional printing method of claim 11, wherein bonding is performed by successive positioning above the section of the sheet material of a heating unit and a cooling unit so as to transfer heat and cool successively thereto, further comprising controlling at least one of the following parameter of the bonding: interface pressure of the heating unit, interface pressure of the cooling unit, temperature of the heating unit, temperature of the cooling unit, speed of displacement of the heating unit, and speed of displacement of the cooling unit.
